# EUROPEAN PATENT APPLICATION

(11) **EP 1 447 863 A2**
(43) Date of publication of application: **18.08.2004**
(21) Application number: 04003434.0
(22) Date of filing: 16.02.2004
(51) Int. Cl.: H01L 51/40, H01L 21/027

(54) **Etching mask**

(30) Priority: 17.02.2003 JP 2003037932; 03.02.2004 JP 2004026888
(71) Applicant: Pioneer Corporation, Meguro-ku, Tokyo (JP)
(72) Inventor: Shiratori, Masahiro, Corp. Research & Dev. Labor., Tsurugashima-shi Saitama 350-2288 (JP); Nagayama, Kenichi, Corp. Research & Dev. Labor., Tsurugashima-shi Saitama 350-2288 (JP); Yoshizawa, Tatsuya, Corp. Research & Dev. Labor., Tsurugashima-shi Saitama 350-2288 (JP)
(74) Representative: Manitz, Finsterwald & Partner GbR

(57) **Abstract**

An etching mask includes a pass-through aperture for exposing only a surface to be etched, a protruding periphery portion that protrudes at the periphery of the pass-through aperture, and a recessed portion enclosed by the protruding periphery portion.

## Description

### BACKGROUND OF THE INVENTION

### 1. Field of the Invention

The present invention relates to patterning methods used in the manufacture of organic electroluminescence elements and the like, and particularly relates to etching masks.

### 2. Description of the Related Art

Organic electroluminescence elements are known as elements that make use of organic compound material thin-films (hereafter, referred to as "organic films") that provide electroluminescence. (hereafter, referred to as "EL") by the injection of an electric current. Organic EL elements are made up of, for example, a transparent electrode, one or more organic films, and a metal electrode layered in order on a transparent substrate.

An organic EL display panel that has a plurality of organic EL elements as light emitting portions, a matrix-type display panel for example, is made up of horizontal line electrodes including a transparent electrode layer, one or more organic films, and vertical column electrodes that intersect with the line electrodes and include a metal electrode layer, layered in order. Each of the line electrodes is formed in a band shape, and the line electrodes are arranged parallel to each other with predetermined spacings. The column electrodes are likewise arranged. In this way, a matrix-type display panel is provided with a picture display arrangement made up of light emitting pixels of a plurality of organic EL elements formed at the intersecting portions of the plurality of line and column electrodes.

In the manufacturing process of the organic EL display panel, an organic film is formed after a transparent electrode layer is formed on a transparent substrate. The organic film is formed by vapor deposition or the like with one or more layers of thin film corresponding to light emitting pixels.

Conventional patterning methods for thin films include photolithography and laser ablation.

In photolithography, first a resist is applied to a thin film formed on a substrate, and then the resist is exposed. After that, a resist mask is formed by dissolving the resist exposure portions of a predetermined pattern in a developer solution (positive type), or by the resist portions becoming difficult to dissolve (negative type), and by etching the thin film, patterns are formed with portions that are etched and portions that are not etched.

Furthermore, with a laser ablation method, thin film is vaporized and stripped by irradiating focused laser light onto the thinfilm,and byselectively repeating this procedure, patterns are formed with portions that are stripped and portions that are not stripped. (See, Japanese Patent Application Kokai No. H01-14995)

As an example of one method of manufacturing an organic EL element, when an organic film is formed with a wet process or the like such as spin coating on the entire surface of a substrate on which first display electrodes have been patterned, the organic film on electrode lead portions must be removed in order to achieve contact with the first display electrodes. For this reason, patterning is performed with a stripping process such as that described above.

Ordinarily, when using a photolithography method that is used in thin film patterning to manufacture organic EL elements, there is the problem that the characteristics of the organic EL elements deteriorate due to solvents in the photoresist penetrating the element, or the elements being subjected to a high temperature atmosphere during resist baking, or the elements being penetrated by resist developer solution or etching solution.

Photolithography cannot be used with organic films that are susceptible to solvents such as developer solutions. Furthermore, with laser ablation methods, the focus range of the laser is from several tens to several hundreds of microns (µm) at best, and has the drawback of requiring considerable time when performing patterning process on large areas.

### SUMMARY OF THE INVENTION

In order to solve the problems, the present invention provides a dry etching mask that enables accurate pattern formation of organic films and the like used in organic EL elements and the like, a patterning method using the same, an organic EL element with which manufacturing efficiency can be improved, and a manufacturing method for such display panels.

To achieve the object, according to one aspect of the present invention, there is provided an etching mask having a pass-through aperture for exposing only a surface to be etched, which comprises a protruding periphery portion that protrudes at the periphery of the pass-through aperture, and a recessed portion enclosed by the protruding periphery portion.

To achieve the object, according to another aspect of the present invention, there is provided a thin film pattern forming method for forming a predetermined pattern on a thin film, which comprises forming at least one thin film on a substrate; and performing a dry etching process for placing a dry etching mask on the at least one thin film that has been formed and for applying an etching gas thereto; wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

To achieve the object, according to another aspect of the present invention, there is provided a method for manufacturing an organic electroluminescence element comprising at least one organic film that is placed between electrode layers and provides electroluminescence, which comprises forming at least one organic film on a substrate; and performing a dry etching process for placing a dry etching mask on the at least one organic film that has been formed and for applying an etching gas to at least one of the at least one organic film; wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

To achieve the object, according to another aspect of the present invention, there is provided an organic electroluminescence element that is manufactured through an organic electroluminescence element manufacturing method having steps of forming at least one organic film on a substrate on which an electrode layer has been pre-laid; and performing a dry etching process for placing a dry etching mask on the at least one organic film that has been formed and for applying an etching gas thereto, which comprises at least one electroluminescence film provided the electrode layer and any other subsequently formed electrode layer; wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

### BRIEF DESCRIPTION OF THE DRAWINGS

FIG. 1 is a schematic plan view of an etching mask according to an embodiment of the present invention;
FIG. 2 is a cross section along line AA in FIG. 1;
FIG. 3 is a schematic plan view of an etching mask according to another embodiment of the present invention;
FIG. 4 is a plan view of an enlarged portion of an etching mask according to another embodiment of the present invention.
FIG. 5 is a cross section along line AA in FIG. 3;
FIG. 6 is a schematic cross section of a portion of a substrate in a thin film pattern forming method according to an embodiment of the present invention;
FIG. 7 is a schematic cross section of a portion of a substrate in a thin film pattern forming method according to an embodiment of the present invention;
FIG. 8 is a schematic cross section of a portion of a substrate in a thin film pattern forming method according to an embodiment of the present invention;
FIG. 9 is a schematic cross section of a portion of a substrate in an organic EL element manufacturing method according to another embodiment of the present invention;
FIG. 10 is a schematic cross section of a portion of a substrate in an organic EL element manufacturing method according to another embodiment of the present invention;
FIG. 11 is a schematic cross section of aportion of a substrate in an organic EL element manufacturing method according to another embodiment of the present invention;
FIG. 12 is a schematic cross section of a portion of a substrate in an organic EL element manufacturing method according to another embodiment of the present invention;
FIG. 13 is a schematic cross section of a portion of a substrate in an organic EL element manufacturing method according to another embodiment of the present invention;
FIG. 14 is a schematic cross section of a portion of a substrate in an organic EL element manufacturing method according to another embodiment of the present invention;
FIG. 15 is a schematic cross section of aportion of a substrate in an organic EL element manufacturing method according to another embodiment of the present invention;
FIG. 16 is a schematic cross section of an etching mask according to another embodiment of the present invention;
FIG. 17 is a schematic cross section of a mask for dry etching according to another embodiment of the present invention;
FIG. 18 is a schematic plan view of a mask for dry etching according to another embodiment of the present invention;
FIG. 19 is a cross sectional view along line AA in Fig. 18;
FIG. 20 schematically shows an enlarged partial sectional view of a mask mother matrix in the manufacturing process of a mask for dry etching according to the embodiment of the present invention;
FIG. 21 schematically shows an enlarged partial sectional view of a mask mother matrix in the manufacturing process of a mask for dry etching according to the embodiment of the present invention;
FIG. 22 schematically shows an enlarged partial sectional view of a mask mother matrix in the manufacturing process of a mask for dry etching according to the embodiment of the present invention;
FIG. 23 schematically shows an enlarged partial sectional view of a mask mother matrix in the manufacturing process of a mask for dry etching according to the embodiment of the present invention;
FIG. 24 schematically shows an enlarged partial sectional view of a mesh structure and a mask mother matrix in the manufacturing process of a mask for dry etching according to the embodiment of the present invention;
FIG. 25 schematically shows an enlarged partial sectional view of a mask for dry etching according to another embodiment of the present invention;
FIG. 26 schematically shows an enlarged partial sectional view of a mask mother matrix in the manufacturing process of a mask for dry etching according to another embodiment of the present invention;
FIG. 27 schematically shows an enlarged partial sectional view of a mask mother matrix in the manufacturing process of a mask for dry etching according to another embodiment of the present invention;
FIG. 28 schematically shows an enlarged partial sectional view of a mask mother matrix in the manufacturing process of a mask for dry etching according to another embodiment of the present invention;
FIG. 29 schematically shows an enlarged partial sectional view of a mother die in the electroforming manufacturing process of a mask for dry etching according to another embodiment of the present invention;
FIG. 30 schematically shows an enlarged partial sectional view of a mother die in the electroforming manufacturing process of a mask for dry etching according to another embodiment of the present invention;
FIG. 31 schematically shows an enlarged partial sectional view of a mother die in the electroforming manufacturing process of a mask for dry etching according to another embodiment of the present invention;
FIG. 32 schematically shows an enlarged partial sectional view of a mother die in the electroforming manufacturing process of a mask for dry etching according to another embodiment of the present invention;
FIG. 33 schematically shows an enlarged partial sectional view of a mother die in the electroforming manufacturing process of a mask for dry etching according to another embodiment of the present invention;
FIG. 34 schematically shows an enlarged partial sectional view of a mother die in the electroforming manufacturing process of a mask for dry etching according to another embodiment of the present invention;
FIG. 35 illustrates a dry etching equipment with use of a mask for dry etching according to the embodiment of the present invention;
FIG. 36 is a graph showing initial characteristics of voltage vs current density of the organic EL devices according to the embodiments of the present invention;
FIG. 37 is a graph showing initial characteristics of current density vs brightness of the organic EL devices according to the embodiments of the present invention;
FIG. 38 is a graph showing initial characteristics of drive time vs brightness of the organic EL devices according to the embodiments of the present invention;

### DETAILED DESCRIPTION OF THE INVENTION

The following is a description of embodiments of the present invention with reference to the accompanying drawings.

### Dry etching mask

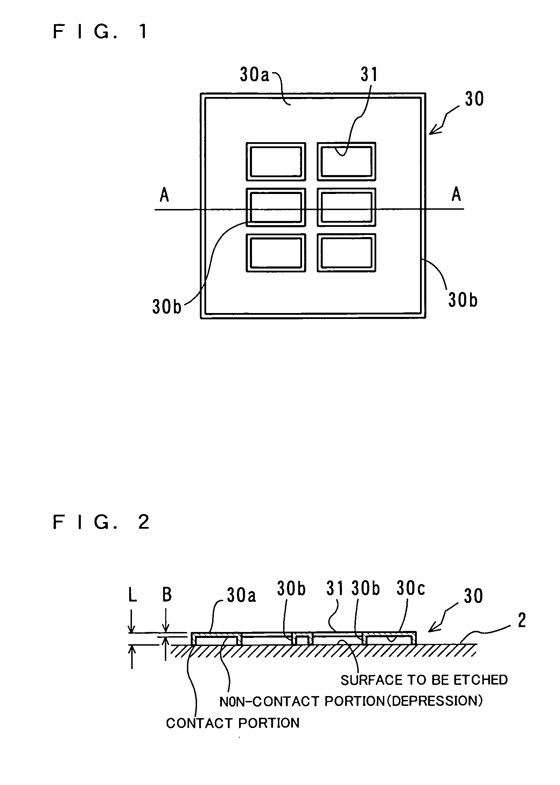

FIG. 1 shows a dry etching mask (hereinafter, also simply referred to as "mask") 30 of a first embodiment of the present invention. FIG. 1 shows a schematic plan view of a mask seen from the side of the object to be etched. The mask 30 is made up of a blocking portion 30a that covers surfaces other than those that are to be etched, and pass-through apertures 31 that enable the exposure of surfaces that are to be etched. The blocking portion 30a is provided with periphery portions 30b that protrude at the peripheries of the pass-through apertures 31, and contact and enclose areas other than those that are to be etched, and a recessed portion 30c enclosed by the periphery portions 30b. That is, the periphery portions 30b have a thickness L that is greater than the thickness B of the recessed portion 30c of the blocking portion 30a. The mask 30 is provided with a plurality of pass-through apertures 31 so that etching gas can pass through. The mask 30 is made of a metal such as nickel or stainless steel (SUS) for example.

As shown in FIG. 2, the areas under the pass-through apertures 31 are etched when dry etching is performed while the mask 30 makes contact on a thin film 2 formed on a substrate, but the areas under the blocking portion 30a, including the receded (depression) portions 30c, are not etched and remain. At this time, the contact regions with the thin film 2 formed on the substrate are only where the protruding portions (i.e., periphery portions 30b) of the blocking portion 30a make contact with a portion of the thin film 2 as shown in FIG. 2. Therefore, due to the recessed portions 30c, the blocking portion 30a does not contact the film, and there causes no damage on the thin film 2. This is effective in such cases as when the thin film to be etched is easily damaged, or when forming further layer (s) of thin film on residual areas after etching.

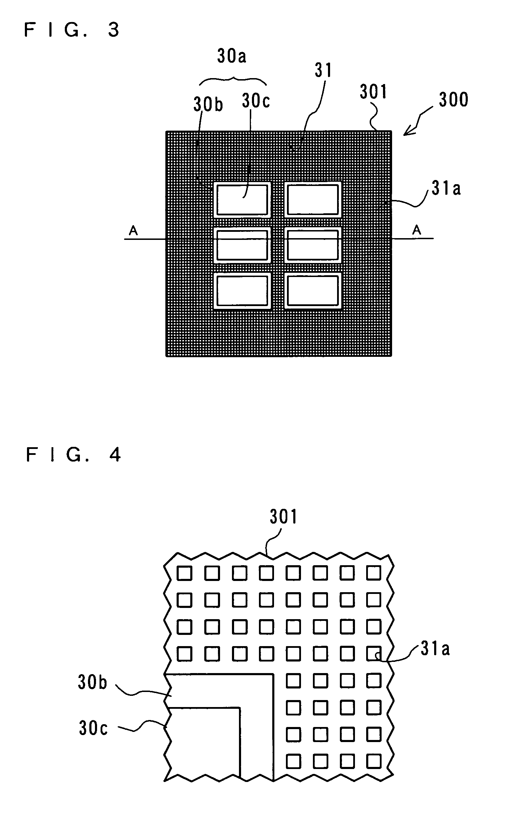

FIG. 3 shows a dry etching mask 300 according to a second embodiment (hereinafter, referred to as "second mask 300"). Fig. 3 shows a schematic plan view of a mask seen from side the of the object to be etched. The second mask 300 is a reversed mask of the mask 30 of the first embodiment described above. The second mask 300 is providedwith ablockingportion 30a including protruding periphery portions 30b and recessed portions 30c, as well as pass-through apertures 31 that are similar to those in the first embodiment. Furthermore, as shown in Fig. 4, the pass-through apertures 31 are covered by a so-called mesh mask, which is a mesh structure 301. The mesh structure 301 has a plurality of pass-through holes 31a (or, net holes). Each of the plurality of pass-through holes 31a has a surface area smaller than the surface area of the pass-through apertures 31.

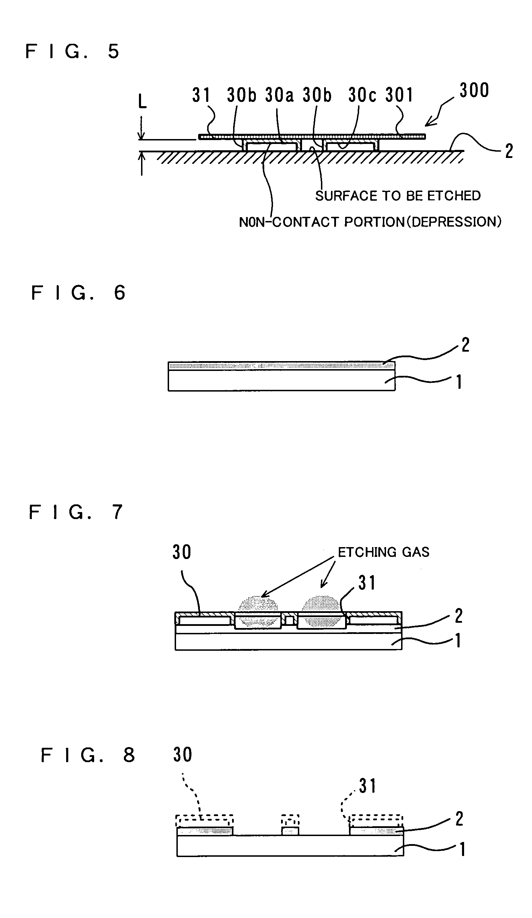

As shown in FIG. 5, the protruding portions (i.e., periphery portions 30b) of the blocking portion 30a that is integrated with the mesh structure 301 contacts only a portion of the thin film 2 formed on the substrate, and the recessed portions 30c of the blocking portion 30a do not contact the thin film formed on the substrate. Furthermore, freely shaped patterning can be realized with the mesh mask 301 which has pass-through apertures 31 formed as a net or mesh. If the distance between the net and the surface to be etched is small, that is, if the thickness L of the periphery portion 30b is insufficient, the plasma gas or other such etching gas does not circulate well behind the net of the aperture portions (on the thin film side), and there may be a residual, net-shaped thin film 2. For this reason, it is necessary to secure a thickness L of the periphery portion 30b to a degree that allows sufficient circulation of the etching gas. Isotropic etching is preferable for good circulation of the etching gas. In this case, the thickness L of the periphery portion 30b must be equal to or greater than the line width of the mesh mask. Although it also depends on the etching method, it is generally preferable that the thickness L of the periphery portion 30b is in the range from 10 to 1,000 µm, or more preferably, from 50 to 500 µm. Furthermore, the mesh density of the mask is preferably 10-mesh to 1, 000-mesh, or more preferably, 100-mesh to 1,000-mesh.

Material that has resistance to etching gases is used for the material of the mesh structure 301 and the blocking portions 30a. For example, metals such as austenitic stainless steel (SUS) are used in plasma ashing equipment.

A patterning method using dry etching with a conventional etching mask has a problem of the etching mask bending because of insufficient mask strength, for example, when the mask pattern is such that aperture portions are large with a fine island-shape pattern of multiple light emitting portions, or with a striped pattern, but the blocking portion is of a fine pattern. Thus, fine patterns cannot be formed. However, with the mesh structure 301 according to the embodiment, the stiffness of the etching mask can be improved, and fine island-shape patterns and line-and-space patterns can be formed.

### Thin film pattern forming method using dry etching

As a thin film forming process, as shown in FIG. 6, a thin film 2 is formed on a substrate 1 such as a glass resistant to etching gases. The deposited thin film 2 may be organic or inorganic.

Then, as an etching process, the mask 30 of the first embodiment is brought into contact with the thin film 2 on the substrate 1 as shown in FIG. 7, and the areas below the pass-through apertures 31 are etched by being exposed to an etching gas atmosphere.

After the etching process, the substrate 1 under the pass-through apertures 31 is exposed as shown in FIG. 8. The surface of the thin film 2 remaining under the blocking portions 30a is not damaged, since the mask 30 is depressed or concave-shaped.

### Organic EL element manufacturing method including dry etching process

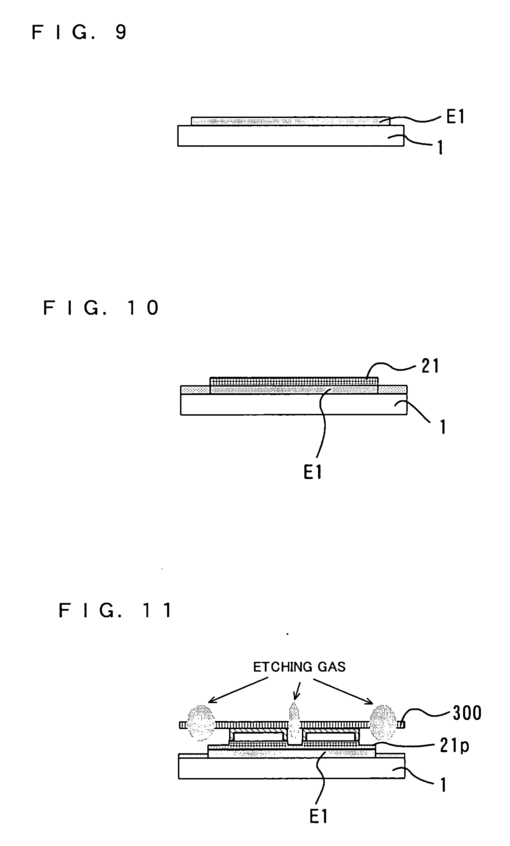

As shown in FIG. 9, a first display electrode E1 which is resistant to dry etching is formed on a glass substrate.

Then, as shown in FIG. 10, one or more layers of a predetermined organic film 21 are formed on the entire substrate surface and the first display electrode E1. The film forming method at this stage may be a wet process such as a spin coating method, or a screen printing method or the like, or a dry process such as vacuum vapor deposition. Furthermore, it may be a polymeric material layer and/or a non-polymeric material layer. It is also possible to form all layers up to the organic light emitting layer at this stage.

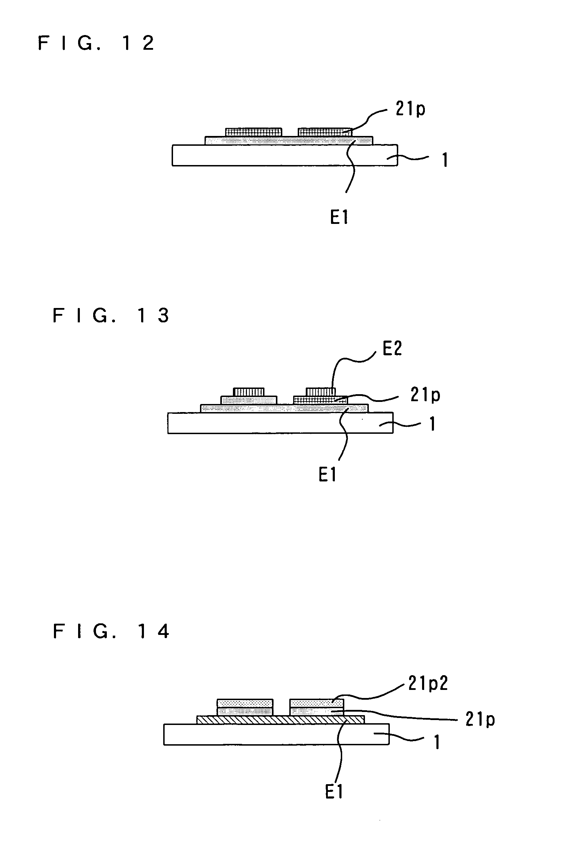

Then, a second mask 300 is placed on the organic film 21 as shown in FIG. 11, and dry etching is performed using the mask. After dry etching has been performed for all organic films, patterning is performed to form organic film pattern 21p as shown in FIG. 12.

Then, a second display electrode E2 is formed on the organic film pattern 21p as shown in FIG. 13.

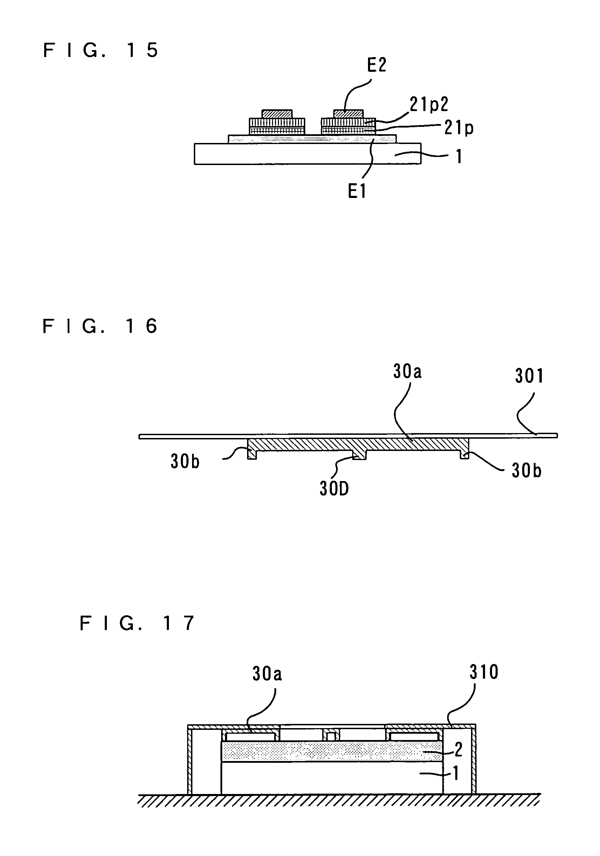

Further still, in the organic EL element manufacturing process, when the second organic film is stacked after dry etching, the steps are executed in the same manner until the step shown in Fig. 12, but after that, as shown in FIG. 14, a second organic film 21p2 (which may include a plurality of layers) is formed on the first organic film as a pattern using a vacuum vapor deposition device or the like, and using a mask or the like. After this, the second display electrode E2 is formed on the second organic film 21p2 as shown in FIG. 15.

### Example of organic EL display panel manufacturing method including dry etching process

A passive matrix organic EL display panel has been manufactured with an organic EL element manufacturing method that uses a mask according to the second embodiment.

First, since light emitting portions are defined at the intersecting portions of the line electrodes and column electrodes, that is, the first and second display electrodes, a plurality of first display electrodes (anodes) that extend parallel to each other are formed on a transparent substrate as follows.

A transparent glass substrate was prepared, and indium tin oxide (hereinafter, referred to as "ITO") was formed on the main surface thereof by sputtering to a film thickness of 1, 500 angstroms (A). Then, a stripe-shaped pattern was formed on the ITO film using a photoresist AZ6112 made by Tokyo Ohka Kogyo Co. , Ltd. The substrate was immersed in a mixture of an aqueous solution of ferric chloride and hydrochloric acid, and portions of the ITO film not covered by the resist were etched. Finally, the substrate was immersed in acetone and the resist was removed, thus obtaining a pattern of a plurality of parallel first display electrodes.

After that, a coating solution obtained by dissolving an acid-doped polyaniline derivative in an organic solvent was spin-coated on the entire surface of the first display electrodes of the substrate obtained in the step of forming the first display electrodes to form a film. Following this, the substrate was heated on a hot plate to vaporize the solvent, thus obtaining a polyaniline film with a film thickness of 450 angstroms (A) on the first display electrodes.

Then, a mesh mask of the second embodiment was placed at a predetermined position on the polyaniline film on the substrate obtained in the step of forming a conductive, polymeric film.

The substrate to which the mesh mask is attached was put into a plasma ashing equipment, and etching was performed for 4 minutes under conditions of plane-parallel anode coupling, RF 1,000 W, O₂: 225 sccm, Ar: 75 sccm, pressure: 62 Pa, 80ºC, then the mesh mask was removed. As a result, the polyaniline film portions under the aperture portions of the mesh mask were completely removed, and the patterns of a portion of the first display electrodes were exposed, while the portions of polyaniline film that were to become the display portions of the organic EL element remained undamaged under the blocking portions. It should be noted that the protruding portion of the mesh mask was formed so that light emitting portions were avoided. Furthermore, the plasma ashing equipment was a resist stripping equipment, in which a reaction was caused between a plasma gas and the resist, and the resist was vaporized and removed. For example, an organic material such as a resist material becomes CO₂, H₂O, O₂ or the like that chemically reacts with oxygen plasma to be gaseous and removed from the substrate.

Then, NPABP (4,4'-bis [N-(1-naphthyl)-N- phenylamino]) biphenyl) with a film thickness of 250 angstroms (A), and Alq3 (tris (8-hydroxyquinoline) aluminum) with a film thickness of 600 angstroms were formed sequentially as organic films by vapor deposition at predetermined positions on the polyaniline films on the substrate obtained in the step of dry etching.

Subsequently, a plurality of second display electrodes (cathodes) extending parallel to each other and perpendicular to the first display electrodes were formed on the organic films on the substrate obtained in the step of organic film formation. Specifically, stripes of an Al-Li alloy with a film thickness of 1,000 angstroms were formed by a deposition method at predetermined positions on the Alq3 film, thus a plurality of organic EL elements arranged in a matrix were completed on the substrate.

Then, in a N₂ atmosphere, an adhesive was supplied between the substrate on which the plurality of organic EL elements obtained in the step of second display electrode formation are formed, and the recessed portion periphery of the glass substrate to which a BaO drying agent had been applied, thus sealing the plurality of organic EL elements, and completing the organic EL display panel according to the present invention.

As a result, the light emitting performance of the sealed organic EL display panel was excellent, and defects such as dark spots, particle adherence, and damage to the organic film were not observed, since the mask was not brought into contact with the organic film.

Although the above-described embodiment is of a passive matrix type organic EL display panel, it is apparent that the present invention can be applied to an active matrix organic EL display panel. Furthermore, the embodiment was described in terms of the simplest structure of an organic EL element made up of the first display electrodes, the organic film, and the second display electrodes, but it is also possible to provide other components on the substrate, for example, the barrier walls disclosed in Japanese Patent Applications Nos. H08-315981 and H08-227276. In this case, these components are not easily damaged, and the present invention is even further effective.

As another embodiment, it is possible to increase the protrusion portions as shown in FIG. 16 in order to more reliably avoid contact of the mask recessed portion to surfaces other than surfaces to be etched. In this case, an auxiliary protruding portion 30D is provided at a non-light emitting portion at the recessed portion enclosed by the periphery portion. The auxiliary protruding portion 30D may also be applied when there is no mesh structure 301, as well as a case in which the mesh structure 301 is provided.

As another embodiment, in order to avoid a charge building up in the mask on the insulating substrate when performing plasma etching, the mask being made of a metal such as austenitic stainless steel (SUS), a grounding portion 310 may be provided that is connected to a portion of the mask, for example, the blocking portion 30a as shown in FIG. 17, grounding the mask to the electrodes of the plasma ashing equipment.

In the above-described embodiments, the recessed portions of the mask do not come in contact with the substrate, and consequently there is no particle adherence to the organic film, and no damage to the organic film, and therefore it is possible to provide an organic EL display panel having organic EL elements that can provide excellent display without defects.

### Manufacturing method of a mask for dry etching

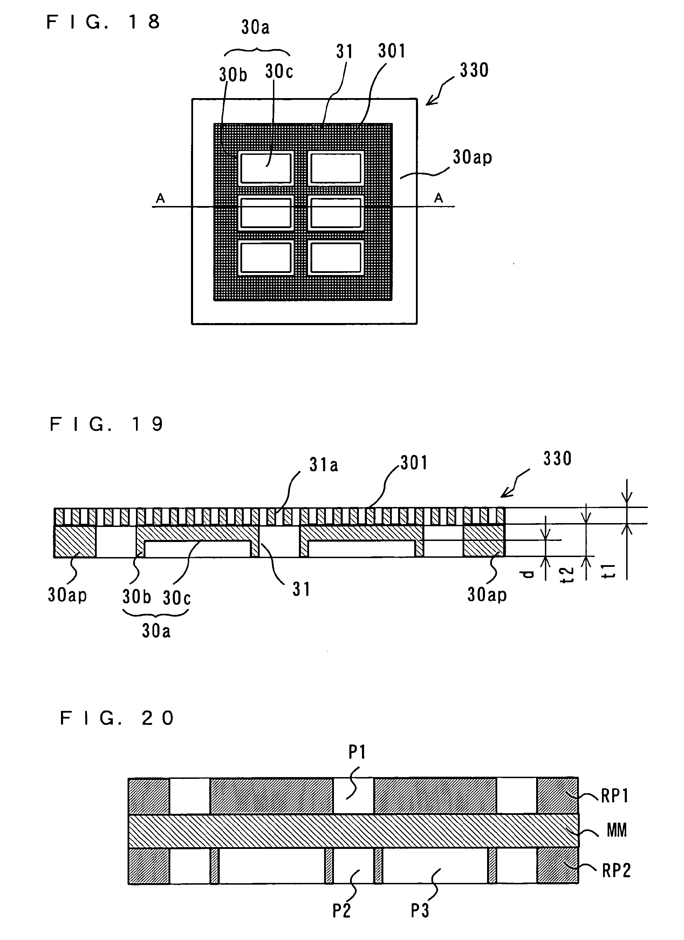

Fig. 18 shows a mask 330 for dry etching (hereinafter, referred to as the third mask 330) according to the third embodiment of the present invention. Fig. 18 shows a schematic plan view of a mask seen from side of the object to be etched. Six blocking portions 30a in a central area correspond to the portions where the thin film should be remained after etching. In addition, a blocking portion 30ap on a peripheral portion serves as a frame body which contacts with the substrate (or with the film which formed on the substrate and to be processed) so as to increase the contact area of the substrate and the third mask 330 to obtain stable contact therebetween.

Fig. 19 shows a cross sectional view along the line AA of the third mask 330 shown in Fig. 18. The third mask 330 has a structure in which the discrete members, that is, the mesh structure 301 and the blocking portion 30a are integrally coupled. The blocking portion and the mesh structure 301 of the third mask 330 are attached together in which the blocking portion has a thickness t2 and the mesh structure 301 has a thickness t1, the mesh structure 301 including a recessed portion having a depth "d". It is preferable that the blocking portion 30ap in a peripheral portion is formed so as not have a recessed portion on the side at which the mask 330 contacts with the substrate, for the purpose of increasing the strength of the third mask 330.

### Manufacturing method of the third mask

The third mask 330 can be manufactured, for example, in the following manufacturing process.

As shown in Fig. 20, resist patterns RP1, RP2 are respectively formed on the sides of a mask mother matrix MM of a plane plate made up of stainless steel, for example. There is provided in a resist pattern RP1 an aperture P1 for exposing only the surface which should be etched (which corresponds to the pass-through aperture 31 in Fig. 19). There is provided, in another resist pattern RP2, apertures P2and P3 for exposing only the surface which should be etched (which correspond to the pass-through aperture 31 and the recessed portion 30c of Fig. 19).

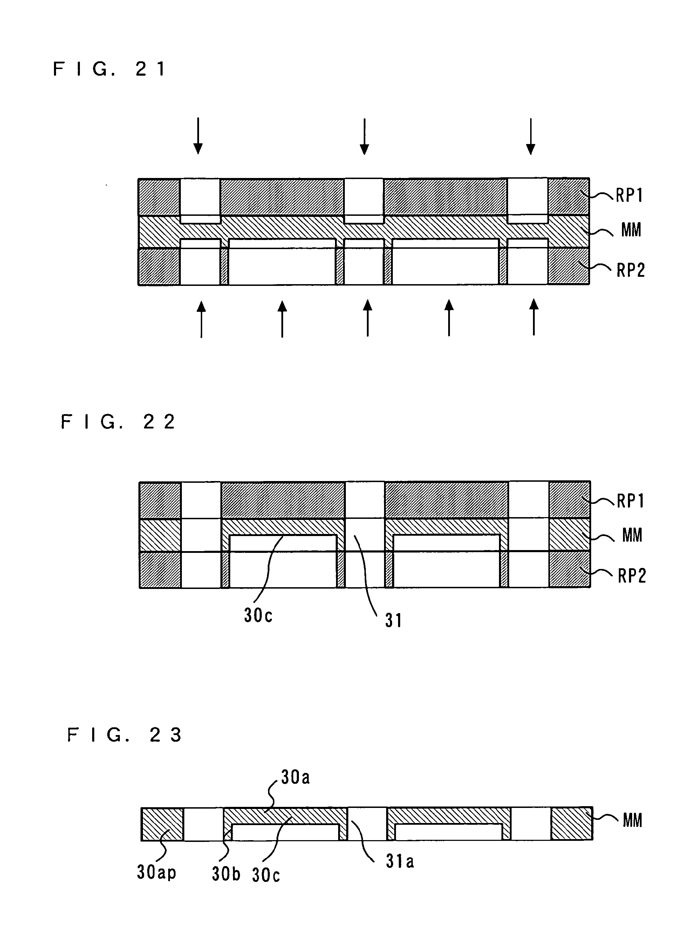

As shown in Fig. 21, a wet etching processing is performed on both sides of the mask mother matrix MM. Specifically, the maskmother matrixMM is etched on both sides thereof using a solution including a material, for example, an acid to dissolve the mask mother matrix MM.

As shown in Fig. 22, the pass-through apertures 31 and the recessed portions 30c are formed by etching. The etching is finished when the depth of the recessed portion 30c is reached a desired depth and the portion of the aperture 31 is penetrated through.

As shown in Fig. 23, the patterned resist on both sides of the mask mother matrix MM is stripped off. The patterned resist can be stripped off by using, for example, an alkali solution, an organic solvent or an oxygen plasma processing. Accordingly, there is provided the mask mother matrix MM which has a blocking portion 30ap on the periphery, a pass-through aperture 31 and a recessed portion 30c.

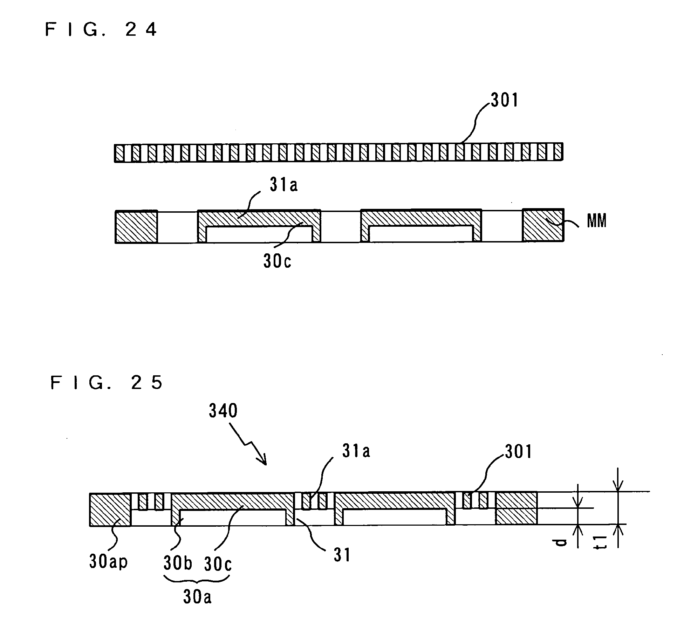

As shown in Fig. 24, a mesh structure 301 is attached to the obtained mask mother matrix MM. Then, a mesh structure 301 which is manufactured in another manufacturing process is attached by an adhesive or by means of a plating processing on the opposite side of the blocking portion 30ap in a peripheral portion and the recessed portion 30c of the blocking portion 30a. Thus, the third mask 330 is provided as shown in Fig. 19.

The mesh structure 301 can be manufactured with the similar etching process. Alternatively, the mesh structure 301 can be manufactured by means of electroforming (plating) technology. Furthermore, the mesh structure 301 can be manufactured by combining wires consisting of, for example, metal or fiber.

With reference to Figs. 20 to Fig. 22, it is described a method of forming the blocking portion 30a by using a both-side etching, however, the etching processing can be performed for each side respectively. Alternatively, the blocking portion 30a can be formed by using an electroforming technique.

### Fourth mask and the manufacturing method thereof:

Fig. 25 shows a cross sectional view of a fourth mask 340. The fourth mask 340 has a structure in which the mesh structure 301 and the blocking portion 30a are formed by etching in one piece, but not formed as an integral of the discrete members. In the fourth mask 340, the mesh structure 301 is formed in only the pass-through aperture 31 between the blocking portion 30ap of a peripheral portion and the blocking portion 30a. Total thickness of the fourth mask 340 is t1, and a recessed portion of depth "d" is provided in the blocking portion 30a. It is preferable that the blocking portion 30ap in a peripheral portion is formed so as not have a recessed portion on the side at which the fourth mask 340 contacts with the substrate, for the purpose of increasing the strength of the fourth mask 340.

The fourth mask 340 can be manufactured, for example, in the following manufacturing process.

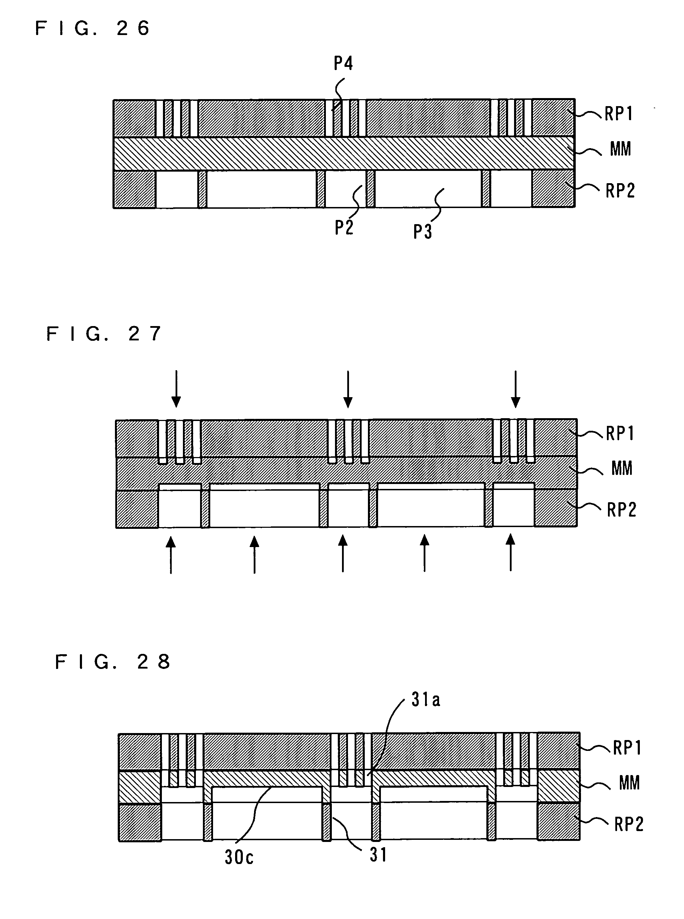

As shown in Fig. 26, resist patterns RP1, RP2 are respectively formed on the sides of a mask mother matrix MM of a plane plate made up of, for example, stainless steel. There is provided in a resist pattern RP1 an aperture P4 for exposing only the surface which should be etched (which corresponds to the pass-through hole 31a in Fig. 25). There is provided, in another resist pattern RP2, apertures P2and P3 for exposing only the surface which should be etched (which correspond to the pass-through aperture 31 and the recessed portion 30c in Fig. 25).

As shown in Fig. 27, a wet etching processing is performed on both sides of the mask mother matrix MM. Specifically, the mask mother matrix MM is etched on both sides thereof using a solution including a material, for example, an acid to dissolve the mask mother matrix MM.

As shown in Fig. 28, the pass-through hole 31a, the pass-through aperture 31 and the recessed portion 30c are formed by etching. The etching is finished when the depth of the recessed portion 30c is reached a desired depth and the portions of the pass-through hole 31a and the aperture 31 are penetrated through.

Then, the patterned resist on both sides of the mask mother matrix MM is stripped off. The patterned resist can be stripped off by using, for example, an alkali solution, an organic solvent or an oxygen plasma processing. Accordingly, there is provided the mask mother matrixMM, as shown in Fig. 25, which has the blocking portion 30ap on the periphery, the mesh structure 301, the pass-through aperture 31 and the recessed portion 30c.

### Another manufacturing method of the fourth mask

A description is made of a manufacturing method to manufacture the fourth mask 340 by electroforming.

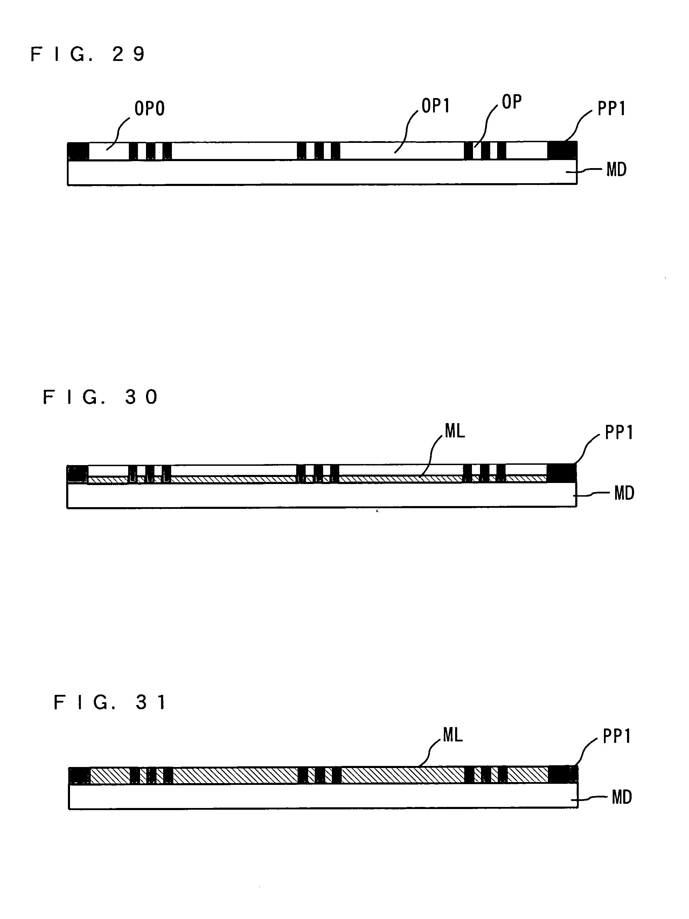

As shown in Fig. 29, a first photo resist pattern PP1 is formed on the principal surface of a mask mother die MD of a plane plate made up of, for example, stainless steel. There is provided in the first photo resist pattern PP1 apertures OP, OP0, OP1 for exposing only the surfaces (which correspond to the mesh structure 301, the blocking portion 30ap on the periphery and the blocking portion 30a in Fig. 25) on which metal should be precipitated or deposited, while the other area is covered.

As shown in Fig. 30, for example, there is prepared an electroforming tank (not shown) provided with an anode therein filled with a solution including nickel ions. The mother die MD is dipped in the electroforming tank. The mother die MD is used as a cathode, and a direct current is passed through between the cathode and the anode for a predetermined time period. Electrodeposition of nickel (Ni) is performed in an exposed surface of the mother die MD to form a metal layer ML of nickel having a thick wall thickness.

As shown in Fig.. 31, the mother die MD is taken out from the electroforming tank to be washed when the thickness of the metal layer ML for the recessed portion of the blocking portion and the mesh structure became a predetermined film thickness (t1-d).

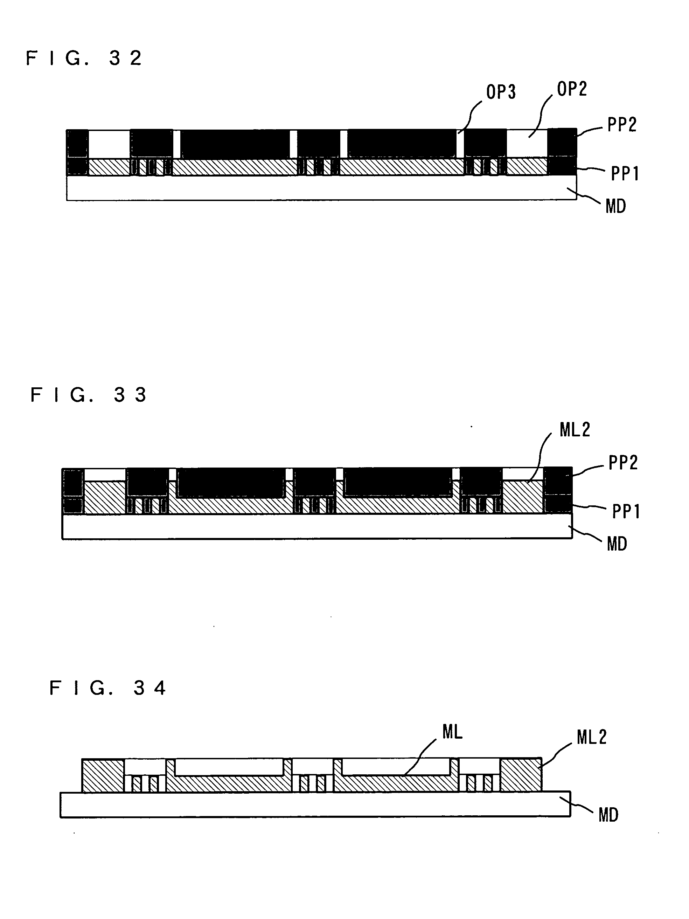

As shown in Fig. 32, a second photo resist pattern PP2 is formed on the first photo resist pattern PP1 and the metal layer ML formed on the mother die MD. There is provided, in the second photo resist pattern PP2, apertures OP2 and OP3 for exposing only the surfaces (which correspond to the blocking portion 30ap on the periphery and the periphery portion 30b of the blocking portion in Fig. 25) on which metal should be deposited, while the other area is covered.

As shown in Fig. 33, the mother die MD having the second photo resist pattern PP2 thereon is dipped in the electroforming tank which provided with an anode therein filled with a solution including nickel ions in a similar manner as described above. The mother die MD is used as a cathode, and a direct current is passed through between the cathode and the anode for a predetermined time period. Electrodeposition of nickel (Ni) is performed on the exposed surface of the mother die MD to form a metal layer ML2 of nickel having a thick wall thickness. The mother die MD is taken out from the electroforming tank to be washed when the total thickness of the metal layer ML1 and the metal layer ML2 for the blocking portion on the periphery and the periphery portion became a predetermined total film thickness.

As shown in Fig. 34, the first and second photo resist patterns are stripped off by using, for example, an alkali solution, an organic solvent or an oxygen plasma processing.

Then, a stack of the metal layers ML and ML2 are separated from the mother die MD. Thus, the fabrication of the fourth mask 340 shown in Fig. 25 is completed.

When producing the fourth mask with electroforming (precipitation method) in the present embodiment, a high processing accuracy of a range of ±1 micrometer (µm) is possible, thereby thickness precision can be improved.

### Embodiment-1: Manufacturing of a mask using electroforming

### Step 1: Manufacturing of the mesh structure 301

Electroforming of Ni in a mesh shape was performed on a mother die made of stainless steel. Only the mother die was removed to fabricate a mesh structure (which corresponds to top half in Fig. 19).

The fabricated mesh structure had a thickness (corresponds to "t1" in Fig. 19) of 0.2mm, a dimension of 50mm × 50mm, and an L/S of 0.025mm/0.038mm (equivalent to 400-mesh).

### Step 2: Manufacturing of the blocking portion

Separately from Step 1, electroforming of Ni was performed on a mother die twice of stainless steel to form a blocking portion pattern (equivalent to bottom half in Fig. 19) having a recessed portion such that the recessed portion was facing to the mother die. The fabricated blocking portion had a thickness (corresponds to "t2" in Fig. 19) of 0.2mm, a dimension of 12mm × 9mm. The depth of the recessed portion (corresponds to "d" in Fig. 19) was 0.1mm and the dimension was 11.6mm × 8.6mm. In other words, the width of the periphery portion that contacted with the substrate was 0.1mm.

### Step 3: Attaching process

Electroforming of Ni was performed on the mesh structure and the blocking portion which were manufactured in Step 1 and Step 2, while the mesh structure and the blocking portion were attached together and fixed to be integrally formed. Then, the mother die of the blocking portion was taken away. The line width of the mesh structure was broadened and an L/S was 0.029mm/0.034mm.

### Step 4: Reinforcement frame installation

A reinforcement frame made up of stainless steel having a thickness of 2mm, a dimension of 50mm × 50mm and a frame width of 3mm is fixed to a periphery of the mask (on the mesh structure of the blocking portion of the peripheral portion) which was manufactured in Step 3 with an adhesive to increase strength of the mask, thus the etching mask of the embodiment was completed.

### Embodiment-2: Patterning of organic thin film

### Step 1: Formation of polyaniline thin film

A glass substrate was washed well and a spin coating of a polyaniline solution which is doped with acid was performed on the glass substrate. After the spin coating, the glass substrate was dried with heating to form a polyaniline film of about 25 nm.

### Step 2: Dry etching

The mask manufactured in the Embodiment-1 was fixed on the glass substrate formed in Step 1 with screws while the mask was brought into intimate contact with the glass substrate. Then, dry etching processing under various kinds of conditions was performed on the polyaniline film using a plasma equipment (a dry etching equipment) V -1000 made by Mori engineering Co., Ltd.

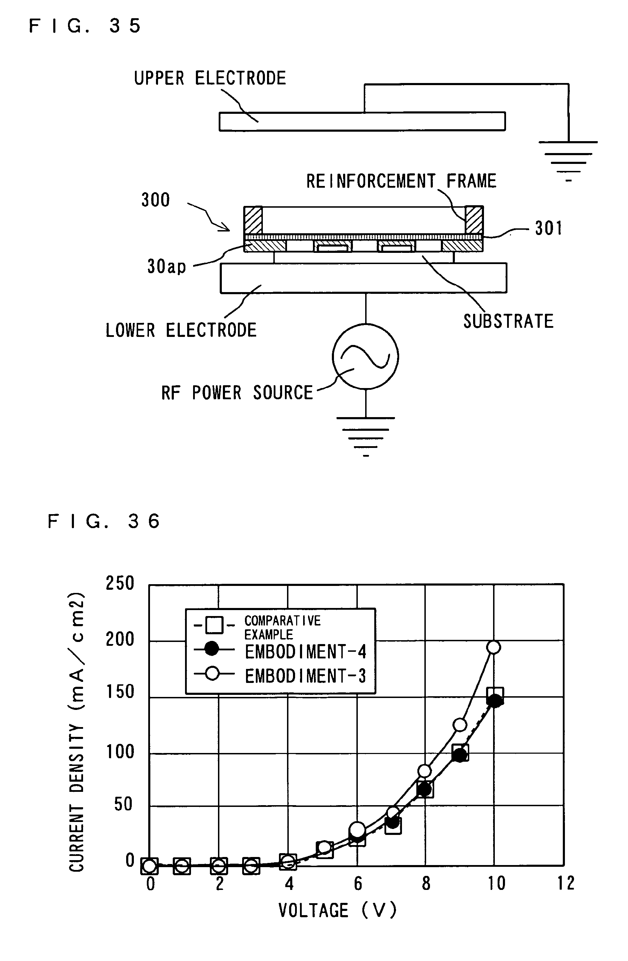

The various conditions of etching were summarized in the following Table 1 and the schematic drawing for illustrating the etching processing is shown in Fig. 35. The substrate was arranged on a lower electrode as shown in Fig. 35. In addition, each of the lower electrode and the upper electrode had the size of 280mm × 280mm, and the distance between the lower and upper electrodes was 40mm. The frequency of the high-frequency (RF) power supply used was 13.6MHz.

The etching processing was performed in two modes in the present embodiment, that is, in a mode in which the RF power supply was connected to the lower electrode as shown in Fig. 35 (hereinafter, referred to as RIE mode), and in a mode in which the RF power supply was connected to the upper electrode (hereinafter, referred to as DP mode).

**Table 1:**

| CONDITION | MODE | GAS | | RF POWER (W) | TIME (min) | RESULT |
|---|---|---|---|---|---|---|
| | | O₂ (SCCM) | Ar (SCCM) | | | |
| A | RIE | 200 | 0 | 1200 | 5 | OK |
| B | RIE | 120 | 120 | 1200 | 0.5 | OK |
| C | RIE | 120 | 120 | 1200 | 1 | Best |
| D | RIE | 120 | 120 | 1200 | 2.5 | Best |
| E | RIE | 0 | 200 | 1200 | 5 | Good |
| F | DP | 250 | 250 | 1200 | 5 | OK |
| G | DP | 250 | 250 | 1200 | 10 | Best |
| H | DP | 250 | 250 | 1200 | 20 | Best |
| Notes: In Table 1, "RESULT" indicates the state of the etched portion. In the "RESULT" provided in correspondence with each of the etching condition in Table 1, "Best": completely removed, "Good": residual substance of a mesh pattern was remained, and "OK": slightly thin film was remained. | | | | | | |

Generally, in the RIE mode, a high etching rate is provided and productivity can be improved since plasma occurs on the lower electrode side, i.e., the substrate side. However, the substrate temperature is easily increased so that caution must be taken. For example, there will be a case in which the substrate must be cooled when using a substrate or a film of low heat resistance. On the contrary, in the DP mode, plasma occurs on the upper electrode side, i.e., at a distance away from the substrate. Therefore, a rise of the substrate temperature can be suppressed, although the etching rate is low.

After performing the etching under each of the conditions described above, visual inspection was made on the polyaniline film. The portions which were not covered by the blocking portions were etched, and etching was performed in a shape approximately the same as that of the blocking portions. The measurements of dimensions regarding the polyaniline film pattern were performed. The dimension had a deviation within less than ±0.1mm for all of the samples. Therefore, it is ensured that the dimensional accuracy was in a practical range. It is assumed that the dimensional accuracy of within ±0.1mm was obtained because the adhesion of the substrate and the mask was incomplete due to mechanical fixation. Therefore, higher patterning accuracy can be achieved by improving adhesion of the substrate and the mask. For example, patterning precision can be improved by adopting a magnetic substance to the substrate and adhering the substrate and the mask by means of a magnet, thereby achieving a patterning accuracy less than ±0.1mm.

Furthermore, a polyaniline film pattern was observed by an optical microscope to inspect the etching quality. The result is also shown in Table 1.

The result can be analyzed as follows.

### (1) RIE mode and DP mode

Comparing, for example, the condition C of the RIE mode and DP mode and the condition F of the DP mode polyaniline film was remained even though there was much quantity of gas flow and the etching time is long in the RIE mode. Therefore, it was confirmed that the etching rate of the RIE mode was much larger than that of the DP mode.

### (2) Kind of etching gas

Comparing the condition A using O₂, the condition C using the mixed gas of Ar/O₂ and the condition E using only Ar, etching is performed well in 1 minute when the mixed gas of Ar/O₂ is used. On the other hand, the film was not completely removed with 5 minutes etching when only O₂ is used, and a residual substance was remained in a mesh structure shape when only Ar is used.

In the dry etching of an organic film, Ar physically etches the organic film so that the etching is anisotropic in which etching is likely to proceed in the perpendicular direction (i.e., anisotropic etching gas). On the other hand, O₂ etching has the significant effect of chemical etching in which O₂ etches an organic film while reacting with the organic material so that the etching is rather isotropic (i.e., isotropic etching gas).

In the etchingusing onlyAr, aresidual substance was remained in a mesh structure shape. This may be because Ar gas did not come around in the backside of the net.

As for the physical etching effect, Ar is stronger than O₂ generally. When the reaction product which is hard to react with O₂ is generated on the surface of the organic film in the etching processing, O₂ does not perform etching effectively, whereas Ar easily performs etching since Ar is superior in physical etching effect. This may be the reason why the etching rate is small when only O₂ is used.

Therefore, it is preferable to perform etching with a mixed gas of an inert gas such as Ar and a gas which is reactive with the organic layer in order to perform uniform etching and to achieve a high etching rate. Uniformity of etching can be achieved by coming around of the etching gas at the backside of the net.

When the patterning method of the organic layer in the embodiment is applied to an organic Electroluminescence device, deterioration of device characteristic is a matter of concern, since the organic layer is exposed to plasma. Further experiment was performed for examining this matter.

### Embodiment-3: Manufacturing of organic EL device 1

### Step 1: Formation of ITO

On a grass substrate having the size of 30mm x 30mm, ITO was formed in a stripe pattern of 2mm width.

### Step 2: Formation of Polyaniline film as a hole injection layer

The glass substrate of Step 1 was washed well and a spin coating of a polyaniline solution which is doped with acid as hole injection layer was performed on the glass substrate. After the spin coating, the glass substrate was dried with heating to form a polyaniline film of about 25 nm.

### Step 3: Etching of Polyaniline film

Etching of polyaniline film was performed in a similar manner to that of the Embodiment-2. The etching condition used was a condition D of Table 1.

### Step 4: Manufacturing of the other layers in the organic EL device

On the substrate of Step 3, NPABP of 45 nm, Alq3 of 60 nm and Li₂O of 1 nm were formed by vacuum deposition with the use of a mask. Further, as the cathode, Al stripes each having 2mm width were formed by vacuum deposition along the orthogonal direction to the ITO.

### Step 5: Encapsulation

A concave-shaped glass , to which BaOwas attached as desiccant, was cemented to the device of Step 4 and encapsulated. Thus the organic EL device of the embodiment was completed.

### Embodiment-4: Manufacturing of organic EL device 2

An organic EL device of the embodiment was fabricated in much the same way as in Embodiment-3 except that the etching condition of the polyaniline was performed with condition H of Table 1 at Step 3 in Embodiment-3.

### Comparative example 1

An organic EL device of the embodiment was fabricated in much the same way as in 3) of Embodiment-3 except that the patterning of the polyaniline was performed by wiping with a wiper.

### Evaluation of the fabricated device

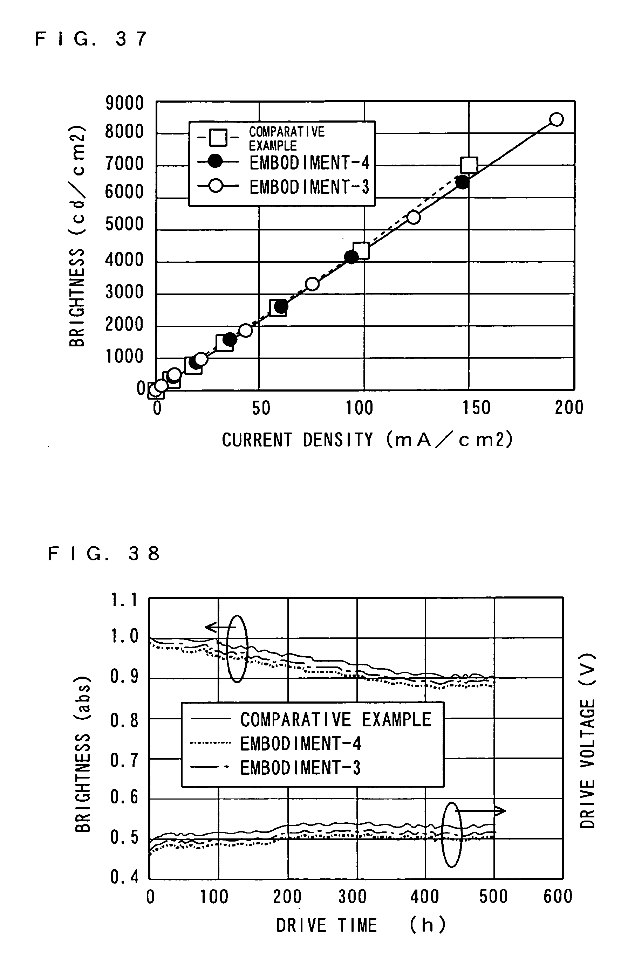

The measurement result on the initial characteristics of the organic EL devices fabricated as described above are shown in Figs. 36 and 37. In addition, brightness degradation characteristics is shown in Fig. 38 when the devices were driven with a DC current of 210mA/cm2.

FromFig. 36-38, the devices of Embodiment-3 and Embodiment -4 showed the approximately the same characteristic as that of the comparative example 1. Therefore, it is found that the etching method in the embodiments did not exert an adverse influence on the organic layers which composed the organic EL devices. The reason is considered that the blocking portions of the mask prevented the incidence of high energy particles, for example, secondary electrons or ions of O₂ and Ar into the polyaniline layers.

Therefore, when applying the etching method in the embodiment to an organic EL device, it is necessary for a blocking portion of a mask to use the materials which can prevent these high energy particles which are generated in the etching processing. It is preferable to use an electrically conductive material such as metal since the material captures charged particles or ions.

The invention has been described with reference to the preferred embodiments thereof. It should be understood by those skilled in the art that a variety of alterations and modifications may be made from the embodiments described above. It is therefore contemplated that the appended claims encompass all such alterations and modifications.

## Claims

1. An etching mask having a pass-through aperture for exposing only a surface to be etched, comprising a protruding periphery portion that protrudes at the periphery of the pas s - through aperture, and a recessed portion enclosed by the protruding periphery portion.

2. The etching mask according to claim 1, wherein the pass-through aperture is covered by a mesh structure provided with a plurality of pass-through holes, each of the plurality of pass-through holes having an area that is smaller than the area of the pass-through aperture.

3. The etching mask according to claim 1 or 2, further comprising a blocking portion in a periphery portion of the etching mask at the side where the recessed portion on the periphery of the pass-through aperture exists.

4. The etching mask according to claim 1 or 2, further comprising a reinforcement frame which is provided at the opposite side of the recessed portion on the periphery of the pass-through aperture.

5. The etching mask according to claim 1, wherein the recessed portion is made of conductive material.

6. The etching mask according to claim 1, wherein the recessed portion is made of metal.

7. A thin film pattern forming method for forming a predetermined pattern on a thin film, comprising:
forming at least one thin film on a substrate; and
performing a dry etching process for placing a dry etching mask on the at least one thin film that has been formed and for applying an etching gas thereto;
wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

8. The thin film pattern forming method according to claim 7, wherein the pass-through aperture is covered by a mesh structure provided with a plurality of pass-through holes, each of the plurality of pass-through holes having a area that is smaller than the area of the pass-through aperture.

9. A method for manufacturing an organic electroluminescence element comprising at least one organic film that is placed between electrode layers and provides electroluminescence, comprising:
forming at least one organic film on a substrate; and
performing a dry etching process for placing a dry etching mask on the at least one organic film that has been formed and for applying an etching gas to at least one of the at least one organic film;
wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

10. The organic electroluminescence element manufacturing method according to claim 9, wherein the pass-through aperture is covered by a mesh structure provided with a plurality of pass-through holes, each of the plurality of pass-through holes having an area that is smaller than the area of the pass-through aperture.

11. The organic electroluminescence element manufacturing method according to claim 9 or 10, wherein the etching gas includes an anisotropic etching gas.

12. The organic electroluminescence element manufacturing method according to claim 9 or 10, wherein the etching gas includes an anisotropic etching gas and an isotropic etching gas.

13. The organic electroluminescence element manufacturing method according to claim 9 or 10, wherein the etching gas includes an oxygen gas.

14. The organic electroluminescence element manufacturing method according to claim 9 or 10, wherein the etching gas includes an oxygen gas and an inert gas.

15. The organic electroluminescence element manufacturing method according to claims 9-14, wherein the step of performing a dry etching process performs etching of the organic film while connecting the substrate to a high frequency power source.

16. An organic electroluminescence element that is manufactured through an organic electroluminescence element manufacturing method having steps of forming at least one organic film on a substrate on which an electrode layer has been pre-laid; and performing a dry etching process for placing a dry etching mask on the at least one organic film that has been formed and for applying an etching gas thereto, comprising:
at least one electroluminescence film provided the electrode layer and any other subsequently formed electrode layer;
wherein the dry etching mask is provided with a pass-through aperture for exposing only a surface to be etched, and is provided with a protruding periphery portion that protrudes at the periphery of the pass-through aperture, and a recessed portion enclosed by the protruding periphery portion.

17. The organic electroluminescence element according to claim 16, wherein the pass-through aperture is covered by a mesh structure provided with a plurality of pass-through holes, each of the plurality of pass-through holes having a area that is smaller than the area of the pass-through aperture.
